(19)

Europäisches
Patentamt
European
Patent Office
Office européen
des brevets

(11) **EP 1 923 922 A1**

(12) **EUROPEAN PATENT APPLICATION**

(43) Date of publication:
**21.05.2008 Bulletin 2008/21**

(51) Int Cl.:
*H01L 33/00* *(2006.01)*

(21) Application number: **06124144.4**

(22) Date of filing: **15.11.2006**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK RS**

(71) Applicant: **Lemnis Lighting IP GmbH
6304 Zug (CH)**

(72) Inventor: **Rooymans, Johannes Otto
Ermelo 3853 NR (NL)**

(74) Representative: **Rasser, Jacobus Cornelis et al
Howrey LLP
Rembrandt Tower
Amstelplein 1, 31st Floor
1096 HA Amsterdam (NL)**

(54) **Improved led lighting assembly**

(57)    Disclosed is a LED-based lighting assembly comprising: a) a disc (10) of ceramic material having a mounting surface (11) and an attachment surface (12); b) a layer of an electric and heat conducting material (13) covering at least part of the mounting surface of the disc; and c) at least one LED (17) mounted on the mounting surface of the disc, said LED being in heat-conductive contact with the electric and heat conducting material. The assembly provides sufficient galvanic insulation for it to be used safely even when connected to the electric grid as a power source.

Fig 1

EP 1 923 922 A1

## Description

BACKGROUND OF THE INVENTION

1. Field of the Invention

The present invention relates to a lighting assembly comprising one or more light emitting diodes. The invention addresses the need for providing adequate galvanic insulation while ensuring sufficient dissipation of heat generated by the light emitting diodes when they are in use.

2. Description of the Related Art

Until a decade ago, light emitting diodes were primarily used in situations requiring lower levels of brightness, such as indicator lights on electronic equipment. The light emitting diodes used for this purpose have a low power consumption and accordingly generate relatively small amounts of heat when in use.

Other uses, requiring greater levels of brightness, include traffic lights and automobile taillights have been developed in the past decade. For these uses, the single color character of light emitting diodes is not a hindrance. In fact, it is used to advantage. Although multiple light emitting diodes are generally used for this kind of application, they can be placed sufficiently far apart that heat dissipation is not a major problem.

It has been suggested to use a combination of light emitting diodes of different colors to produce light that approximates what is considered white light. For a proper mixing of the light from different light emitting diodes it is necessary for optical homogeneity to place these diodes in close physical proximity to each other. Accordingly, dissipation of heat generated by the light within diodes becomes more problematic. For use as a light source competing in brightness with a conventional incandescent light bulb or even halogen light, a lighting assembly based on light emitting diodes requires the use of so-called power LEDs, which further increases the challenge posed by the heat dissipation requirement.

On the other hand, it is important to provide sufficient galvanic insulation of the LED chip assembly from its required heat sink in order to ensure safe handling and use of a light emitting diode based lighting assembly, in particular if the light assembly is to be connected directly to the electric grid as a power source, as distinguished from being connected to a source of low voltage electricity. The needs to provide galvanic insulation and heat dissipation tend to contradict each other.

It is an object of the present invention to provide a LED based lighting assembly that provides sufficient heat dissipation even if the assembly comprises a plurality of light emitting diodes placed closely together, while at the same time providing sufficient galvanic insulation for the lighting assembly to be safely used with the power grid as its power source.

SUMMARY OF THE INVENTION

The present invention relates to a LED based lighting assembly comprising:

a) a disc of ceramic material having a mounting surface and an attachment surface;

b) a layer of an electric and heat conducting material covering at least part of the mounting surface of the disc;

c) at least one LED mounted on the mounting surface of the disc, said LED being in heat-conductive contact with the electric and heat conducting material.

Preferably, the electric and heat conducting material is a metal. The layer of electric and heat conducting material may have a thickness in the range of from 5 to 40 micrometers, preferably from 10 to 30 micrometers.

The lighting assembly of the present invention is particularly suitable for use with a plurality of light emitting diodes which, in combination, emits white light.

BRIEF DESCRIPTION OF THE DRAWINGS

Figure 1 shows a schematic cross section of a lighting assembly according to the present invention.

Figure 2 shows a circuit diagram of a preferred lighting assembly for use in the present invention.

Figures 3a, 3b, and 3c show the voltage patterns at different points in the circuit of Figure 2.

Figure 4 is a top view of the lighting assembly of Figure 1.

DESCRIPTION OF ILLUSTRATIVE EMBODIMENTS

The present invention relates to a LED based lighting assembly comprising:

a) a disc of ceramic material having a mounting surface and an attachment surface;

b) a layer of an electric and heat conducting material covering at least part of the mounting surface of the disc;

c) at least one LED mounted on the mounting surface of the disc, said LED being in heat-conductive contact with the electric and heat conducting material.

As a general proposition, many electric conducting materials are also heat conducting materials. However, for the power needs of even the bright power LEDs, the electric power requirements are small, on the order of a few Watts. Layers of electric conducting materials used in conjunction with LEDs are therefore generally very thin. This allows for these layers to be deposited by thin-film techniques, such as generally applied in the semiconductor industry for integrated circuits and packaging industry. The deposition of thin layers may be realized by a method such as plating, chemical vapor deposition, or sputtering.

For the purpose of the present invention, such layers are not considered "heat conducting" simply because they are too thin to dissipate a meaningful amount of heat. To be considered a "layer of heat conducting material" within the meaning of the present invention, it is preferred that the layer have a thickness in the range of from 5 to 40 micrometers, preferably from 10 to 30 micrometers. Preferred materials for use in this layer of heat conducting material are metals, in particular silver, gold, copper, and aluminum. Silver is most preferred.

Because of the desired thickness it is generally not convenient to deposit the layer of heat conducting material by means of a thin-film technique. It has been found that lithographic techniques are suitable for depositing heat conducting layers of the thickness desired for the lighting assembly of the present invention. Lithographic techniques have the disadvantage, as compared to thin-film deposition techniques, that the surface of the deposited layer is comparatively rough. It may be necessary to subject the layer to a post-treatment after deposition, to decrease the surface roughness of the layer. Examples of suitable post-treatment techniques include galvanization or lepping (polishing).

The main purpose of the disc of ceramic material is to provide galvanic insulation while maintaining heat conduction. Any ceramic material having the required insulating properties is suitable for this purpose. A secondary purpose of the disc of ceramic material is to provide mechanical strength to the lighting assembly. Ceramic materials having considerable mechanical strength are therefore preferred. Examples of suitable materials include the so-called refractory oxides, in particular aluminum oxide also known as co-fired ceramics.

The term "disc" as used herein refers to a slice of ceramic material of any suitable shape to accommodate the LED or LEDs of the lighting assembly. The shape may be circular, rectangular, square, or any other geometric shape suitable for the purpose. The disc of ceramic material preferably has a thickness in the range of from 200 to 500 micrometers.

The disc has a mounting surface and an attachment surface. The layer of electric and heat conducting material is provided on the mounting surface of the disc. The LED chip or LED chips are mounted on the mounting surface of the disc, in such a way that they are in heat conducting contact with the electric and heat conducting material. The heat dissipation of the lighting assembly may be further improved by providing a heat sink at the attachment surface of the disc.

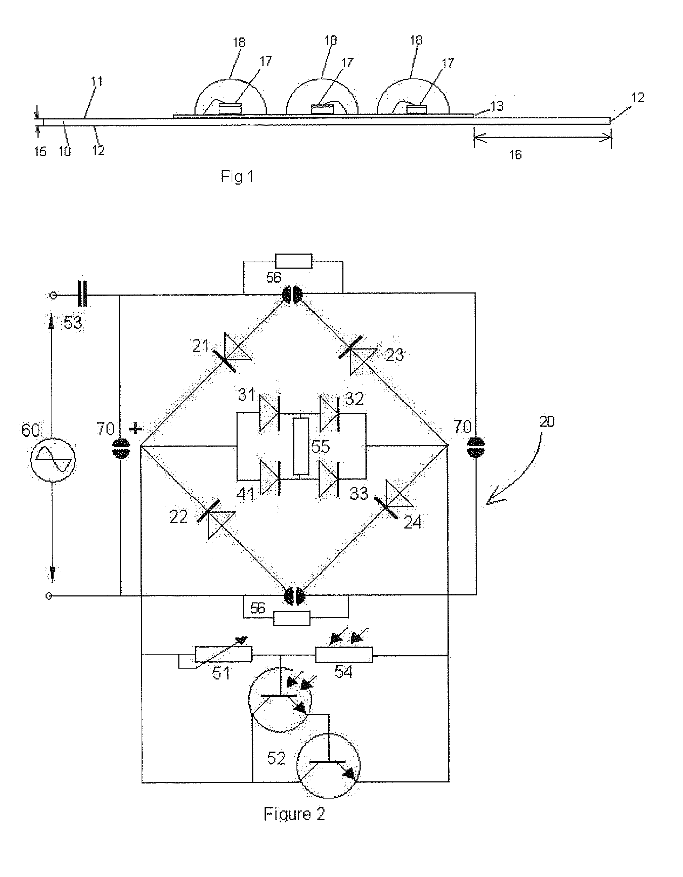

Figure 1 shows a preferred embodiment of the ceramic disc used in the lighting assembly of the present invention. Ceramic disc 10 is shown with its mounting surface facing upward and its attachment surface 12 facing downward. The mounting surface 11 is provided with a layer 13 of an electric and heat conducting material. Disc 10 has a thickness 15. Thickness 15 determines the galvanic insulation value of the ceramic disc. It is preferably in the range of from 200 to 500 micrometers. Layer 13 defines an edge of the ceramic disc having width 16. This edge determines the insulation value with respect to sparking across the surface of the disc. Since the insulating properties of (ionized) air are inferior to those of a ceramic material, width 16 is generally greater than thickness 15. Preferably width 16 is at least 1 mm, more preferably at least 4 to 6 mm. Discs of this type provide the lighting assembly with a galvanic insulation of at least three kV.

Mounted on heat conducting layer 13 are LED chips 17. In this preferred embodiment the LED chips are encapsulated in a dome 18 of substantially transparent material, which may be of a type well known in the art. Examples of suitable materials include epoxy materials and polyurethane materials.

For use as a light source replacing, for example, an incandescent light bulb, it is desirable that the lighting assembly emit light having a color rendering index of at least 80, more preferably a color rendering index of at least 90. In addition, it is desirable to provide light with a color temperature in the range of from 2000 to 8000 Kelvin, more preferably in the range of 2000 to 3700 Kelvin.

In a preferred embodiment, the lighting assembly of the present invention comprises a first group of at least four LEDs and a second group of at least one LED. The at least four LEDs of the first group form a rectifier circuit bridge. This arrangement makes it possible to connect the circuit to either an alternating current source or a direct current source, as will be explained in more detail with reference to Figure 2.

When the circuit is connected to an alternating current source, the LEDs of the rectifier bridge emit light that is flashing at a frequency equal to the frequency of the cycles of the alternating current source. This frequency is of a relatively low value, for example 50 hertz in most European countries and 60 hertz in North America. Different from incandescent light bulbs, light emitting diodes stop emitting light immediately when the power supply is interrupted. As a result, a light emitting diode connected to the power grid emits light that the human eye may experience as unstable and flickering. For this reason, it is preferred to use red LEDs emitting light having a peak wavelength in the range of 600 nm to 630 nm for the at least four LEDs in the rectifier bridge which alternate between each other. The human eye is not very sensitive to light in his wavelength range, and therefore no unpleasant flickering is experienced.

The intermittent direct current coming off the rectifier bridge can be used to power the LEDs of the second group. This intermittent direct current has a frequency that is twice the value of that of the connected alternating current source. As result, the LEDs of the second group can be selected to emit light in wavelength areas where the human eye is more sensitive, such as green. In a preferred embodiment the second group comprises at least one green LED, emitting light having a peak wavelength in the range of 500 to 560 nm and at least one blue LED emitting light having a peak wavelength in the range of 460 to 500 nm. In a still further preferred embodiment, the second group consists of three green LEDs and one blue LED.

Figure 2 shows a circuit 20 representing a preferred embodiment of the present invention. The four LEDs 21, 22, 23, and 24 of the rectifier bridge are red LEDs emitting light having a peak wavelength in the range of 600 nm to 630 nm. These four red LEDs provide power to the second group, which consists of three green LEDs 31, 32, and 33, and one blue LED 41. Preferably the green light emitting LEDs have a peak wave length in the range of 500 - 560 nm, and the blue LED has a peak wave length in the range of 460 - 500 nm. It has been found that this arrangement provides light that can be considered white, with a color temperature in the range of from 2000 to 8000 Kelvin. Importantly, it has been found that the color temperature can be adjusted in the range of 8000 Kelvin to 2000 Kelvin. The latter is experienced as pleasant and warm by the human eye. It has heretofore not been possible to effectively generate light of this color temperature using LEDs.

An important advantage of this multiple LED configuration is the ability to apply same-colored LED chips with a substantial spread in dominant wavelength within the ranges mentioned hereinabove. The spreading allows less critical binning, resulting in a higher yield of the usable chips, and therefore reducing cost. Advanced sorting techniques for the optimal spreading of wavelength within the same embodiment will be desirable.

Shown further in Figure 2 is potentiometer 51. This potentiometer can be used to adjust the intermittent direct current supplied to the LEDs of the second group, which results in an adjustment of the color temperature of the light emitted by the lighting assembly. It has surprisingly been found that adjustment by means of the potentiometer results in a change in the color temperature of the emitted light substantially along the blackbody curve. In other words, the adjustments do not result in a major deviation from what is considered natural white light. This feature is a highly attractive aspect of this embodiment of the present invention.

The brightness of LEDs generally varies with the temperature of the LED, in particular the temperature at the p-n transition layer also called junction (Tj). This temperature is determined by the rate at which heat is generated within the LED, and the rate at which the heat can be dissipated to the environment. As a result, the operating temperature of the LED tends to vary with fluctuations in the ambient temperature. LEDs of different color types respond differently to fluctuations in the ambient temperature. This means that the color of the light emitted by the assembly tends to shift if the ambient temperature goes up or down. Although it is possible to adjust the color temperature by means of potentiometer 51, this requires manual intervention and is therefore not very practical.

Light sensor 54 is provided to ensure continuous and automatic fine-tuning and maintaining of the color temperature through dynamic feedback. If, because of external circumstances such as an increase in ambient temperature, the amount of red light emitted by the LED assembly drops, light sensor 54 acts to reduce the amount of electric power fed to the LEDs of the second group. In the embodiment of Figure 2, the power to the three green LEDs and the one blue LED is reduced. This re-balances the color mix of the light emitted by the assembly. The power supply to the red LEDs 21, 22, 23 and 24 is not modulated by the transistor since the bridge is powered by a constant current source. This has no perceptible effect on the perceived color, because the human is less sensitive to light intensity changes. Darlington transistors are preferred for use as regulating transistor 52, because of their high current response. A bare darlington transistor chip can also act as light sensor.

The lumen maintenance over the life time of the red and green LEDs is different. Red LEDs consisting of AlInGaP compound have a much better lumen maintenance over the years of life time than green GaN LEDs. This ageing over the years can also be compensated with the same transistor circuit as used for the heat compensation, since this circuit is based on an optical dynamic feedback. This requires a light sensor in series with potentiometer (51).

For a further improvement of the spectral distribution of the light emitted by the assembly it is desirable to add to the circuit at least one amber LED (not shown), having a peak wave length in the range of 570 - 590 nm.

A particular advantage of the arrangement shown in Figure 2 is that the power source may be an alternating current source or a direct current source. This means that the lighting assembly can be connected directly to the electric grid, without a need for a transformer or a separate rectifier. On the other hand, customers desiring a lighting assembly for operation on direct current can be served without the need to make any changes to the manufacturing process. The lighting assembly is identical, whether it is to be supplied from an AC or a DC source. This feature greatly reduces the cost of manufacturing the two types of lighting assemblies, because they share the same circuitry.

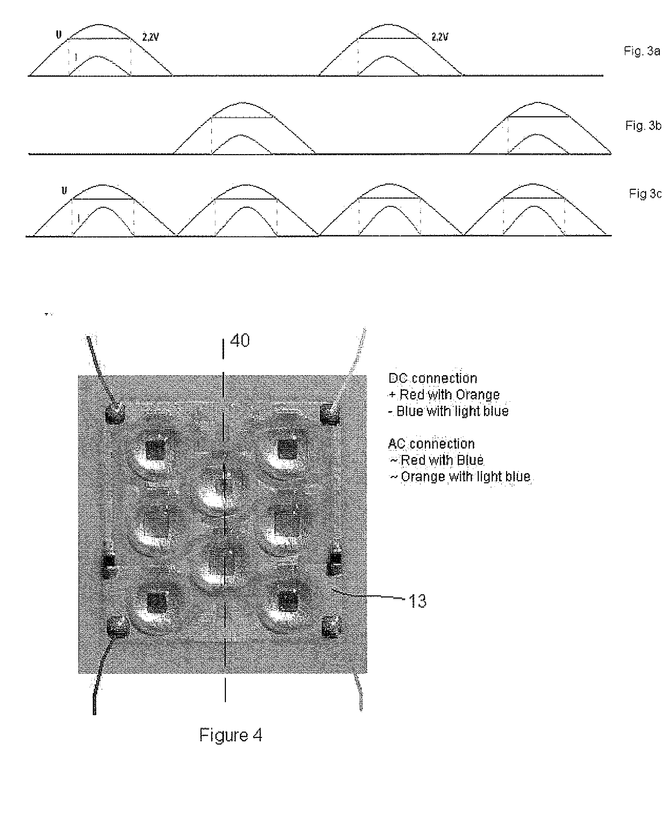

For AC operation the circuit is provided with capacitor 53, which reduces the power received from external AC power source 60, which has a voltage V and a frequency f, to a low voltage intermittent power of the same frequency while maintaining a constant current. For example, AC power of 230 Volts and 50 Hz may be converted to a constant AC current of 350 mA resulting in an AC voltage of 12 Volts over the embodiment. Figure 3a shows the current wave form supplied to LEDs 21 and 24. Figure 3b shows the current wave form supplied to LEDs 22 and 23. As can be seen from Figures 3a and 3b, the two wave forms each have a frequency of 50 Hz, with the wave form of Figure 3b being shifted by ½ cycle relative to that of 3a. LEDs 21 and 24 emit a flashing light with a flashing frequency of 50 Hz. LEDs 22 and 23 also emit a flashing light with a flashing frequency of 50 Hz, offset by ½ cycle. The two sets of LEDs complement each other in that LEDs 21 and 24 emit light when LEDs 22 and 23 do not, and *vice versa.* As a result, the human eye does not discern the flashing character of the emitted light. This effect is further aided by the fact that LEDs 21, 22, 23 and 24 emit light in a wavelength range for which the human eye is not particularly sensitive. Resistor 55 is required to balance the amount of light of the blue LED and has a value between zero and one ohm.

Figure 3c shows the current wave form fed to the LEDs of the second group. This is an intermittent DC with a frequency of 2f, or, in this case, 100 Hz.

It will be understood that the LED chips will emit light only when the voltage of the power feed exceeds a threshold value. Accordingly, even the LED chips of the second group, which are powered by the intermittent direct current of Figure 3c, emit intermittent light. The flashing frequency of these LEDs is twice the frequency of the AC source. In Europe the flashing frequency is 100 Hz if the lighting assembly is powered by the electric grid, and in North America it is 120 Hz. At these frequencies the human eye perceives a constant light.

The capacitance of capacitor 53 may be calculated from the operating voltage $V_{op}$ and the operating current $I_{op}$ of the LED assembly, as follows.

$$V_{op} = V_{op,21} + V_{op,31} + V_{op,32} + V_{op,24},$$

wherein $V_{op,21}$ is the operating voltage of LED 21, etc. obtained from the manufacturer's specification.
The effective resistance $R_{eff}$ of the assembly is calculated from

$$R_{eff} = V_{op}/I_{op}$$

And the reactance $R_x$ of capacitor 52 from

$$R_x = R_{eff} * (V_{ac} - V_{op}) / V_{op}$$

wherein $V_{ac}$ is the voltage of external AC source 60.
Finally, the capacitance C of capacitor 53 is calculated from

$$C = 1/(R_x * 2\pi * f)$$

If $V_{ac}$ = 230 Volts and f = 50 Hz, the required capacitor for an assembly having an operating voltage of 12 V and an operating current of 350 mA is 4.9 μF.

Referring again to Figure 2, instead of AC power source 60, a DC power source 70 may be used by shortcutting the connection pads accordingly.

Electrostatic discharge is harmful to any type of semiconductor, including light emitting diodes. To protect against electrostatic discharge (EDS), varistors 56 is provided, placed in parallel with the LEDs or the plurality of LEDs. With this provision it is possible to provide an electrostatic discharge protection of at least 8 kV.

To protect the LEDs from the environment and to provide mechanical strength, the LEDs are preferably individually encapsulated in a substantially transparent material. This encapsulation serves also a better optical interface from the light emitting junction to the ambient. Suitable transparent materials are well-known in the art. Preferred for use herein are epoxy materials and polyurethane materials.

Although light emitted by red, green and blue can be mixed to a white light, the spectral distribution is not optimum, because wavelengths between 560 and 600 nm are underrepresented in the spectral distribution. It is desirable to substitute to the lighting assembly at least two red LEDs by amber LEDs emitting light having a peak wavelength in the range of 570 to 590 nm. The amber LEDs are preferably placed in alternating order in the bridge of the red LEDs. For example, LEDs 21 and 22 in Fig. 2 may be red ones, and LEDs 23 and 24 may be amber LEDs.

The skilled person will appreciate that the LEDs for use in the lighting assembly may be of the horizontal type or they may be of the vertical type. It is even possible to manufacture the lighting assembly with a combination of LEDs of the horizontal type and often vertical type. This flexibility is another advantage of the lighting assembly of the present invention.

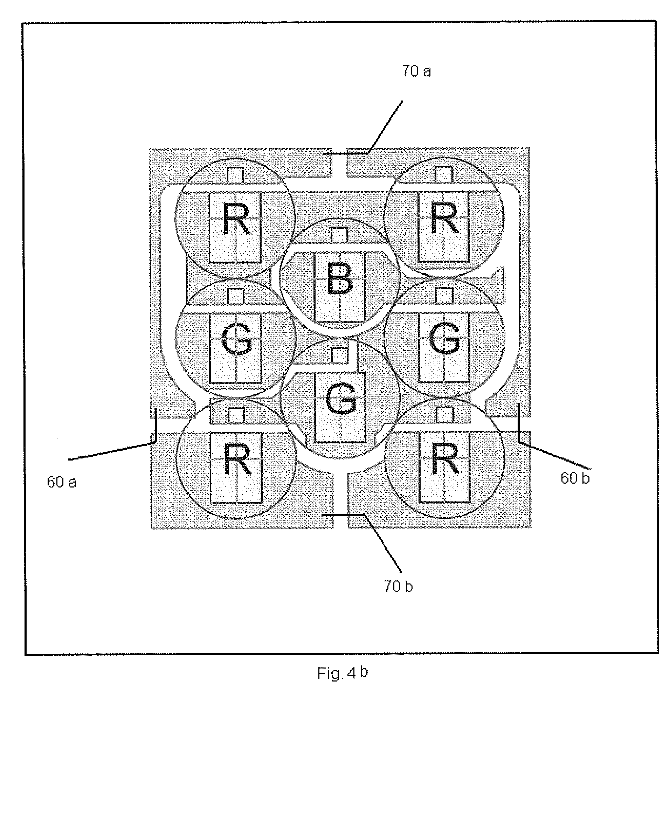

Vertical type LEDs have one electrical connection on the bottom and one at the top of the chip connected to the circuit through a wire bond. The thermal conduction of electric and thermal vertical conducting LEDs is ten times better than horizontal structured LEDs.
A further major advantage of vertical LEDs is the identical planar radiation pattern of the red and green chips resulting in an optimal mix for homogenous white light. The mixing of light of different colors may be further improved by optimizing the geometrical arrangement of the LEDs, for example as shown in figure 4. Preferably the LEDs are arranged in a pattern having one axis of symmetry. In figure 4 the axis of symmetry is indicated by dotted line 40.

Figure 4 shows a top view of a lighting assembly of the present invention. As can be clearly seen, heat conducting layer 13 is provided in such a pattern as to form a circuit as shown in Figure 2. Contact points 60a and 60b are used when the assembly is powered with alternating current. Contact points 70a and 70b are used when the assembly is powered with direct current, with 70a being the connecting point for the positive pole, and 70b for the negative one.

Thus, the invention has been described by reference to certain embodiments discussed above. It will be recognized that these embodiments are susceptible to various modifications and alternative forms well known to those of skill in the art.

**Claims**

1. A LED-based lighting assembly comprising:

   a) a disc of ceramic material having a mounting surface and an attachment surface;
   b) a layer of an electric and heat conducting material covering at least part of the mounting surface of the disc;
   c) at least one LED mounted on the mounting surface of the disc, said LED being in heat-conductive contact with the electric and heat conducting material.

2. The lighting assembly of claim 1 wherein the electric and heat conducting material is a metal.

3. The lighting assembly of claim 1 or 2 wherein the disc has a thickness in the range of 200 to 500 micrometers.

4. The lighting assembly of claim 3 wherein the layer of electric and heat conducting material has a thickness in the range of from 5 to 40 micrometers, preferably from 10 to 30 micrometers.

5. The lighting assembly of any one of the preceding claims wherein the heat conducting material is selected from the group consisting of silver, gold, copper, and aluminum.

6. The lighting assembly of claim 5 wherein the heat conducting material is silver.

7. The lighting assembly of any one of the preceding claims further comprising a heat sink attached to the attachment surface of the disc.

8. The lighting assembly of any one of the preceding claims which emits light having a color rendering index of at least 80.

9. The lighting assembly of Claim 8 which emits light having a color rendering index of at least 90.

10. The lighting assembly of any one of the preceding claims which emits light having a color temperature in the range of from 2000 to 8000 K.

11. The lighting assembly of claim 10 which emits light having a color temperature in the range of 2000 K to 3000 K.

12. The lighting assembly of any one of the preceding claims comprising a first group of at least 4 LEDs and a second group of at least 1 LED, wherein the first group of at least 4 LEDs forms a rectifier circuit bridge.

13. The lighting assembly of claim 12 wherein the first group of LEDs provides a direct current to the second group of LEDs.

14. The lighting assembly of claim 12 or 13 wherein the at least 4 LEDs of the first group are red LEDs emitting light having a peak wave length in the range of 600 nm to 630 nm.

15. The lighting assembly of any one of claims 12 - 14 wherein the second group of LEDs comprises at least one green LED emitting light having a peak wave length in the range of 500 - 560 nm, and at least one blue LED emitting light having a peak wave length in the range of 460 - 500 nm.

16. The lighting assembly of Claim 15 wherein the second group of LEDs consists of 3 green LEDs and one blue LED.

17. The lighting assembly according to any one of claims 13 - 16 having a current regulating circuit across the rectifier bridge for adjusting the direct current supplied to the at least one LED of the second group.

18. The lighting assembly of any one of claims 13 - 17 wherein the current regulating circuit comprises a phototransistor.

19. The lighting assembly according to claim 14 or 15 further comprising at least one amber LED emitting light having a peak wave length in the range of 570 to 590 nm.

20. The lighting assembly according to any one of claims 12 - 19 which is fed from an AC power source.

21. The lighting assembly of any one of any one of claims 12 - 19 which is fed from a DC power source.

22. The lighting assembly of any one of the preceding claims wherein at least one of the LEDs is protected from electrostatic discharge by a varistor in parallel with the at least one LED.

**23.** The lighting assembly according to any one of the preceding claims wherein the disc of ceramic material has an edge, and the layer of heat conducting material has a distance of at least 1 mm from said edge.

**24.** The lighting assembly according to claim 23, wherein said distance is at least 4 mm.

**25.** The lighting assembly of any one of the preceding claims wherein the LED or LEDs are encapsulated in a hemispheric half ball of substantially transparent material.

**26.** The lighting assembly of claim 23 wherein the substantially transparent material is an epoxy material or a silicone or polyurethane material.

**27.** The lighting assembly of any one of the preceding claims wherein the color of the emitted light may be adjusted along the black body curve.

**28.** The lighting assembly of any one of the preceding claims having a galvanic insulation of at least 3 kV.

**29.** The lighting assembly of any one of the preceding claims wherein the LEDs are of the horizontal type.

**30.** The lighting assembly of any one of claims 1 - 28 wherein the LEDs are of the vertical type.

**31.** The lighting assembly of claim 30 wherein the LEDs have similar planar radiation patterns.

**32.** The lighting assembly of any one of the preceding claims wherein the LEDs are arranged in a pattern having at least one axis of symmetry.

**33.** The lighting assembly of any one of claims 1 - 28 comprising at least 2 LEDs, wherein at least 1 LED is of the horizontal type and at least 1 LED is of the vertical type.

Fig 1

Figure 2

Fig. 3a

Fig. 3b

Fig 3c

DC connection
+ Red with Orange
- Blue with light blue

AC connection
~ Red with Blue
~ Orange with light blue

Figure 4

Fig. 4 b

**European Patent Office**

**EUROPEAN SEARCH REPORT**

Application Number

EP 06 12 4144

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/036705 A (TOKYO SHIBAURA ELECTRIC CO [JP]; TOSHIBA MATERIALS CO LTD [JP]; SHIRAI) 21 April 2005 (2005-04-21) * figures 1,3 * | 1-7 | INV. H01L33/00 |
| Y | | 8-11 | |
| E | -& US 2006/269698 A1 (SHIRAI TAKAO [JP] ET AL) 30 November 2006 (2006-11-30) * paragraphs [0027], [0036], [0043], [0044] * ----- | 1-11 | |
| Y | WO 2005/112137 A (SEOUL OPTO DEVICE CO LTD [KR]; LEE CHUNG-HOON [KR]; ROTH GUNDULA [DE];) 24 November 2005 (2005-11-24) * abstract * * paragraphs [0006], [0041], [0042] * ----- | 8-11 | |
| X | EP 1 511 090 A (LUMILEDS LIGHTING LLC [US]) 2 March 2005 (2005-03-02) * abstract; figure 3 * ----- | 1,2,5 | |
| X | US 6 838 702 B1 (HO WEN-CHIH [TW]) 4 January 2005 (2005-01-04) * column 3, lines 1-50; figure 4 * ----- | 1,7 | TECHNICAL FIELDS SEARCHED (IPC) H01L F21K |

~~The present search report has been drawn up for all claims~~

| Place of search | Date of completion of the search | Examiner |
|---|---|---|
| Munich | 16 April 2007 | Meacher, David |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

...................................................................................
& : member of the same patent family, corresponding
     document

EPO FORM 1503 03.82 (P04C01)

European Patent
Office

Application Number

EP 06 12 4144

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

see annex

**European Patent Office**

**LACK OF UNITY OF INVENTION**
**SHEET B**

Application Number

EP 06 12 4144

The Search Division considers that the present European patent application does not comply with the requirements of unity of invention and relates to several inventions or groups of inventions, namely:

```
1. claims: 1-11,21,26

        A lighting assembly that emits light having a color
        rendering index of at least 80
                    ---

2. claims: 12-20,22

        A lighting assembly comprising a first group of at least 4
        LEDs and a second group of at least 1 LED, wherein the first
        group of at least 4 LEDs forms a rectifier circuit bridge.
                    ---

3. claims: 23,24

        A lighting assembly wherein the LED or LEDs are encapsulated
        in a hemispheric half ball of substantially transparent
        material
                    ---

4. claim: 25

        A lighting assembly wherein the color of the emitted light
        may be adjusted along the black body curve.
                    ---

5. claims: 27-31

        A lighting assembly wherein the LEDs are of the horizontal
        type or of the vertical type or at least 1 LED is of the
        horizontal type and at least 1 LED is of the vertical type
        or the LEDs have similar planar radiation patterns or the
        LEDs are arranged in a pattern having at least one axis of
        symmetry
                    ---
```

## ANNEX TO THE EUROPEAN SEARCH REPORT
## ON EUROPEAN PATENT APPLICATION NO.

EP 06 12 4144

This annex lists the patent family members relating to the patent documents cited in the above-mentioned European search report.
The members are as contained in the European Patent Office EDP file on
The European Patent Office is in no way liable for these particulars which are merely given for the purpose of information.

16-04-2007

| Patent document cited in search report | | Publication date | Patent family member(s) | | Publication date |
|---|---|---|---|---|---|
| WO 2005036705 | A | 21-04-2005 | KR 20050107450 A<br>TW 256756 B<br>US 2006269698 A1 | | 11-11-2005<br>11-06-2006<br>30-11-2006 |
| US 2006269698 | A1 | 30-11-2006 | WO 2005036705 A1<br>KR 20050107450 A<br>TW 256756 B | | 21-04-2005<br>11-11-2005<br>11-06-2006 |
| WO 2005112137 | A | 24-11-2005 | CN 1981387 A<br>EP 1766693 A1<br>KR 20050108816 A | | 13-06-2007<br>28-03-2007<br>17-11-2005 |
| EP 1511090 | A | 02-03-2005 | JP 2005079593 A<br>US 2005045901 A1 | | 24-03-2005<br>03-03-2005 |
| US 6838702 | B1 | 04-01-2005 | NONE | | |

EPO FORM P0459

For more details about this annex : see Official Journal of the European Patent Office, No. 12/82